# EUROPEAN PATENT SPECIFICATION

(11) **EP 1 605 591 B1**
(45) Date of publication and mention of the grant of the patent: **27.02.2008**
(21) Application number: 04013688.9
(22) Date of filing: 10.06.2004
(51) Int. Cl.: H03J 1/00, H03J 7/18, H04B 1/16

(54) **A device and a method for tuning a radio receiver unit by frequency band scanning**
Vorrichtung und Methode zur Abstimmung eines Rundfunkempfängers durch Frequenzbandabtastung
Dispositif et procédé pour l'accord d'un récepteur de radiodiffusion par balayage de bande de fréquences

(43) Date of publication of application: 14.12.2005
(73) Proprietor: Ford Global Technologies, LLC, Dearborn, MI 48126 (US)
(72) Inventor: Ekelund, Per, 427 41 Billdal (SE)
(74) Representative: Widahl, Jenny Marie

(56) References cited:
- US-A- 4 491 975
- A. DEMMERS, M. VERHEIJDEN: "User Manual of High-End RDS/EON Car Radio System CCR612" APPLICATION NOTE, [Online] no. AN96029, 24 May 1996 (1996-05-24), XP002304773 EINDHOVEN Retrieved from the Internet: URL:http://www.semiconductors.philips.com/ acrobat_download/applicationnotes/AN96029_ 1.pdf> [retrieved on 2004-11-04]

## Description

### Technical field of the invention

This invention generally relates to a device and a method for tuning a radio receiver unit by frequency band scanning. More particularly, this invention relates to a radio receiver unit and a method for use in for example a vehicle radio receiver, for scanning through a frequency band in search for a receivable station, transmitting a content to be approved by a user.

### Background of the invention

Different types of receivers, which are provided with scanning functionality in order to find receivable stations, are well known in the art. An example of such a receiver is the type of receiver commonly found in a vehicle radio. The demands on a radio receiver for use in a vehicle or the like is somewhat different as compared to stationary receivers, since the receiver is arranged to move around in an area, in which the distance and the communication characteristics to one or several radio transmitter varies. Therefore, many systems have been developed to aid and assist users of mobile radio systems, such as a vehicle radio.

An example of such a system is the Radio Data System (RDS) presently being used in Europe. One of the main functions of this system is the so-called alternative frequency (AF) functionality. In a system exhibiting alternative frequency functionality, a pick list of alternative frequencies to the one presently tuned is contained in a subcarrier of the transmitted signal. This list contains information about transmission frequencies that are all transmitting the exact same content as the one presently tuned. The AF pick list is defined by a program identification code (PI) contained in the subcarrier of the transmitted signal and the PI code is the same for all frequencies transmitting for the same radio station, i.e. content. Together, the alternative frequencies may cover a larger area, such as a region or an entire country with the same program content from one radio station. In this application, this is referred to as a network. There is also a similar system, known as Radio Broadcast Data System (RBDS) used in the US, but since networks presently are very rare there, AF lists and so-called AF switching is not commonly used there at this point in time.

When a user is to find a radio station, transmitting a desired content, this may be done by scanning the frequency band. Usually such a scanning is performed after the user sends a start_scan_command to the receiver, usually by pushing a scanning button on the user panel of the vehicle radio. When such a start_scan_command is received by the tuner, a scanning through the frequency band is initiated, from a start frequency through a subsequent band of frequencies, usually, but not necessarily in ascending frequency order, until a next frequency transmitted by a radio station is found. The receiver stays tuned to this frequency for a predetermined time period, while allowing the user to listen to the content and determine whether he wishes to continue staying tuned to this frequency. If the user wants to stay tuned to this frequency, he issues a stop_scan_command for instance by pushing a stop_scan button on the radio panel, and the receiver stays tuned to this frequency. Then, AF functionality may be used to find alternative frequencies transmitting the same content. Otherwise, the receiver automatically resumes the scanning for the next frequency with a radio station in the frequency band after a predetermined time, whereafter the above process is repeated. Usually, when scanning, the AF function is switched off, in order to avoid undesired frequency jumps.

An example of such a prior art radio receiver unit is disclosed in US44491975, which relates to a radio receiver unit which performs a frequency band scan by:
- scanning through the frequency band from a start frequency through a subsequent band of frequencies,
- stopping the scan at a stop frequency transmitted by a first radio station,
- storing the stop frequency in a memory,
- reproducing the first radio station for a predetermined time, and
- continuing the scanning through the frequency band , starting the scanning at the stop frequency stored in the memory.

However, a problem with the prior art methods for scanning a tuner is that they are limited in their functionality, and during some circumstances, it may take a long time to find a station transmitting a desired radio content.

### Summary of the invention

Hence, it is an object of the present invention to overcome the above mentioned drawbacks with the prior art.

A further object of this invention is to provide an improved receiver unit for mobile radio systems, such as a vehicle radio.

Yet an object of this invention is also to enable a full scanning of an entire frequency band, especially in areas with bad and/or quickly shifting reception.

A further object is also to achieve a radio receiver unit in which a scanning may be performed in a more efficient manner, having a better performance and a more reliable operation.

The above and other objects are at least in part achieved by a radio receiver unit for use in a radio network environment, the receiver unit comprising means for enabling a scanning through a radio frequency band in search for a radio station transmitting a desired radio content, wherein the receiver unit is arranged to halt a scanning through the radio frequency band at a stop frequency transmitted by a first radio station and having a signal quality above a predetermined search_stop_level, whereafter the radio receiver unit is arranged to reproduce said first radio station for a predetermined scanning stop time period, the receiver unit further comprising a memory, in which the stop frequency is stored, at least until the expiry of said predetermined scanning stop time period. By providing a memory in the radio receiver and storing the stop frequency in this memory, it is possible to resume a disrupted scanning from the same frequency as the receiver unit was receiving when the scanning was halted. This is advantageous for instance in the situation described below and enables scanning with AF functionality turned on. A user operates a vehicle radio, provided with AF functionality, and the user wishes to perform a scanning through the frequency band for a new radio station, transmitting on another frequency and having another content than the presently tuned radio station on frequency A. The user initiates the scanning, and the radio receiver unit usually searches for stations transmitting at higher frequencies. A station is found at a frequency B, for instance 89,3 MHz, but this station is not very strong, but it is above a predetermined search_stop_level, and therefore the radio receiver unit halts the scanning at this frequency for a predetermined amount of time, such as 10 seconds. However, this station at frequency B is part of a network and is therefore sending out an alternative frequency pick list, which is read by the radio receiver unit, and stored in a memory. At this point, the vehicle travels into an area with worse reception, such as into a tunnel, and since AF functionality is active, the tuner automatically checks whether there is an alternative frequency in the alternative frequency pick list having a better reception. The radio unit finds such a frequency, and then jumps to this frequency C (for instance 95,6 MHz). This jump is difficult to notice for a user. However, the content transmitted by the station on frequency C is the same as transmitted on the stop frequency B, and the user listens to this content for the predetermined amount of time, and decides he does not want to listen to this station at the moment. Hence, the user does not stop the scanning during the predetermined amount of time, but allows the scanning to continue. However, without this invention the scanning would continue from the alternative frequency C, and not from the stop frequency B, and hence the scanning would miss the frequency interval between the frequencies B and C (in the present example, between 89,3 MHz and 95,6 MHz). Instead with this invention, the stop frequency B is stored in a memory, and by utilising the value of the stop frequency when resuming the scanning, the scanning may be performed over the entire frequency band, without risk of missing frequency intervals as described above. Hence, this invention ensures that all frequencies within the frequency band may be covered by a scanning, without unwanted unpredictable jumps, thereby ensuring that a user is subjected to all possible options regarding stations to stay tuned to. The stop frequency may further by stored in the memory until a new stop frequency have been found in a subsequent search. In that case, if a stop_scan_command is issued before a new stop frequency has been found, the receiver unit jumps back to the first stop frequency, stored in the memory, and stays tuned to the station transmitting on this frequency. Preferably, the inventive radio receiver is arranged to be mounted in a vehicle.

Suitably, said receiver unit is arranged to resume the scanning through the radio frequency band from the stored stop frequency, at the expiry of said predetermined scanning stop time, unless a stop_scan_command has been issued by a user during said predetermined scanning stop time. Thereby, any unwanted jumps when scanning a frequency band as described above may be avoided. The stop_scan_command may for instance be issued by a user, who wishes that the radio unit stays tuned to the station transmitting on the stop frequency.

Also, said radio receiver unit is suitably arranged to, during said predetermined scanning stop time, stay tuned to said first radio station on any frequency, selected from an alternative frequency pick list containing said stop frequency, having a signal quality or a signal strength above a predetermined search_stop_level. Thereby, the radio receiver is always tuned to a frequency with a desired content having a good reception at the moment, giving the user a pleasant audio experience. During a predetermined scanning stop time, the radio receiver may be tuned to several alternative frequencies transmitted by the same station. It shall be noted that it is sufficient that the signal quality for a presently tuned frequency is satisfactory, not necessarily among the frequencies with the highest signal strengths of the alternative frequency picklist.

Alternatively, said radio receiver unit is suitably arranged to, during said predetermined scanning stop time, stay tuned to said first radio station on the frequency, selected from an alternative frequency pick list containing said stop frequency, presently having the highest signal quality of the frequencies in the alternative frequency pick list.

As a further alternative, the radio receiver unit is arranged to stay tuned to said first radio station on said stop frequency, during the predetermined scanning stop time, unless the signal quality for said stop frequency falls below a predetermined signal level. This avoids unnecessary jumps in the frequency band, while still ensuring a selected minimal audio signal quality. In this aspect, the term signal quality is to be construed as including any one of the measures signal strength, signal-to-noise ratio, multipath noise, disturbances from adjacent stations, and frequency noise, or any combinations thereof.

The above and other objects of this invention is also at least in part achieved by a method of performing a frequency band scan to tune a radio receiver unit in a vehicle, comprising the steps of scanning through the frequency band, from a start frequency through a subsequent band of frequencies, stopping the scan at a stop frequency, transmitted by a first radio station and having a signal level above a pre-determined search-stop-level, storing said stop frequency in a memory, keeping the radio receiver unit tuned to said first radio station for a predetermined scanning stop time, and continuing said scanning through the frequency band, starting the scanning at said stop frequency, stored in said memory. The advantages of this method are the same as indicated above.

Suitably, the step of continuing said scanning through the frequency band, further comprises the steps of checking whether a stop_scan_command has been issued during said predetermined scanning stop time, and, if such a stop_scan_command has not been issued, continuing said scanning through the frequency band, starting at said stop frequency, stored in said memory. Thereby, any unwanted jumps in the frequency band while scanning for a desired radio content may be prevented. However, if a user wants to continue to listen to the tuned radio station, he activates a stop_scan_command, for instance by pushing a button or a touch screen on a user panel of the radio receiver unit, whereafter the radio unit terminate the scanning functionality and stays tuned to the selected station (i.e. the station transmitting at the stop frequency) and the scanning is aborted.

According to an embodiment of this invention, the step of keeping the radio receiver unit tuned to said first radio station for a predetermined scanning stop time, further comprises the steps of determining an alternative frequency pick list for said stop frequency, monitoring the signal quality of the presently tuned frequency, and, if the signal quality of the presently tuned frequency falls under a predetermined threshold, selecting an alternative frequency within said alternative frequency picklist, having a signal quality over a predetermined threshold and tuning said radio receiver to this frequency.

Alternatively, the step of keeping the radio receiver unit tuned to the first radio station for a predetermined scanning stop time, further comprises the steps of determining an alternative frequency pick list for said stop frequency, monitoring the signal quality of a presently tuned frequency and the alternative frequencies of the alternative frequency pick list, and, if an alternative frequency in said alternative frequency pick list has a higher signal quality than the presently tuned frequency, tuning said radio receiver into said alternative frequency. In both cases the step of monitoring the signal quality of a presently tuned frequency further comprises the step of monitoring at least one of the signal strength, signal-to-noise ratio, multipath noise, disturbances from adjacent stations, and frequency noise (or any combinations thereof).

The term "radio network environment" as used herein shall be construed as a radio broadcasting environment in which the Radio Data System (RDS), RBDS or a similar system, is incorporated. In particular, the term shall be construed as an environment in which alternative frequency pick lists are present, i.e. lists of frequencies from a tuned station containing alternative frequencies to the presently tuned frequency, the alternative frequencies transmitting the same content as the presently tuned frequency. In this way, by using a radio network, it is possible to cover a larger area, such as a part of a country or an entire country with the same radio content or program. This enables a user to continue to listen to a selected program as the user travels through the area, even if the transmission frequency for the desired radio content is changed.

The term "station" as used herein shall be construed as a content provider, i.e. one station in a radio network environment is arranged to transmit one content on several alternative frequencies, together constituting an alternative frequency picklist. Hence, it is possible to stay tuned to a station by alternatingly staying tuned to two or more different frequencies, all transmitting the same content.

### Brief description of the drawings

The invention will hereinafter be described in closer detail by means of presently preferred embodiments thereof, with reference to the accompanying drawings.
Fig 1 is a flow chart describing the basic steps behind a scanning method utilising this invention.
Fig 2 is a schematic chart disclosing a frequency flow chart for an example of this invention.
Fig 3 is a schematic drawing disclosing a layout of a radio system utilising this invention.

### Description of preferred embodiments of the invention

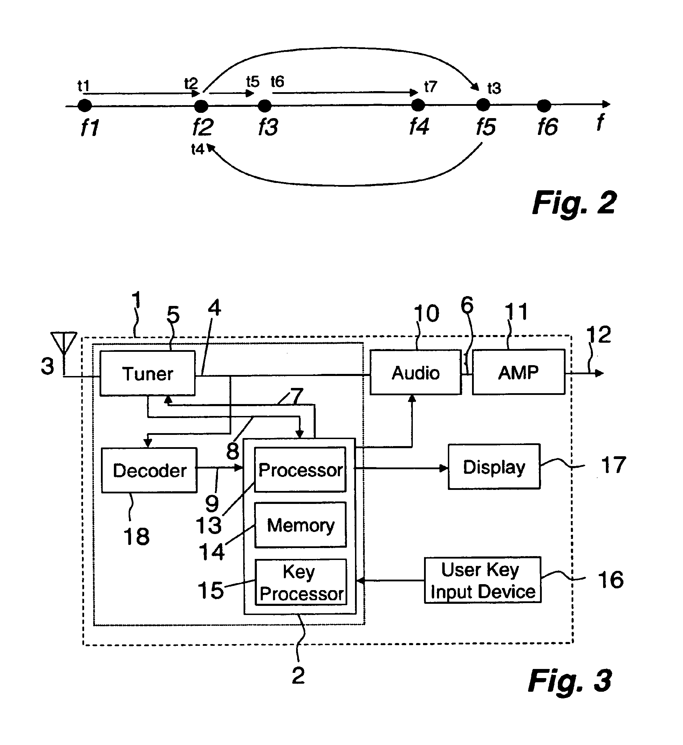

Referring to fig 3, a radio receiver unit 1 according to this invention comprises a tuner 5, being connected to an antenna 3, which is arranged to pick up a radio frequency band and transfer the radio frequency band to the tuner 5. The tuner is arranged to select one frequency from the received radio frequency band and transfer this selected frequency further, as will be described below. Hence, even if a range of frequencies is picked up by the antenna 3, only a selected, received signal 4, having the selected frequency will get past the tuner 5 (schematically disclosed with the numeral 4 at fig 3). The tuner 5 is equipped with an output for transferring the received signal 4, to an audio processor 10. The audio processor 10 is arranged to process the received signal 4 into an audio signal 6, which is transferred to an amplifier 11 and thereafter outputted as an audio output signal 12 through a loudspeaker or the like.

However, a part of the received signal 4 is also transferred to a decoder 18, being arranged to extract RDS data from the received signal 4 (commonly from a subcarrier of the received signal), and to transfer an extracted RDS data signal 9 to a control unit 2. The tuner 5 is also equipped with a signal strength detection means (not explicitly shown) being arranged to detect and transfer a signal strength signal 8 to the control unit 2, the signal strength signal 8 being indicative of a signal strength of said received signal 4. Furthermore, the tuner 5 is arranged to receive a control signal 7 from the control unit 2, the control signal 7 being arranged to tune the tuner 5, i.e. determine the frequency of the received signal 4. That is, by altering the control signal 7, a scanning over a frequency band may be performed by the tuner 5. The control signal 7 is also used to initiate, stop or halt scanning of the frequency band, as will be described below.

The control unit 2 essentially comprises a processor 13, a memory 14 and a key processor 15. The key processor 15 is connected to a user key input device 16, such as one or more buttons on the front of a radio user panel (not shown), the button being arranged to be activated as a user of the radio unit wishes to perform a scanning or the like. That is, by maneuvering the user key input device 16, a user may control the content of the control signal 7 to the tuner and hence what frequency is to be transferred from the tuner as the received signal 4. The control unit 2 is also connected to a display 17, for displaying for instance RDS information gained from said RDS data signal 9, for example containing information regarding transmitted radio station name, etc. The processor 13 is arranged to process the RDS data signal 9 into a message signal which may be transmitted to said display 17. The RDS data signal 9 which is transmitted to the control unit 2 also comprises information regarding an alternative frequency pick list for the received signal 4, which is stored in an alternative frequency pick list memory (not shown) in the tuner. However, as soon as the received signal 4 changes in frequency, a new alternative frequency pick list for the new frequency will be stored in the alternative frequency pick list memory. The processor 13 is also arranged to process the signal strength signal 8 transmitted from the tuner 5, and also to transmit the control signal 7 to the tuner 5. This control signal 7 may contain information to start a scanning of the tuner 5, based on a start_scan_command, issued by the user through the user key input device 16. The control signal 7 may also contain information to permanently or temporarily halt a scanning. A temporary halt may be issued during a scanning when the processor detects that the signal strength signal 8, transmitted from said tuner is above a predetermined search_stop_level 18, which is used as an indication that a new frequency transmitted by a radio station is found. In this case, the temporary halt in scanning is maintained for a predetermined scanning stop time, for instance 10 seconds, allowing a user to listen to the content of the transmitting radio station, and decide whether he wishes to stay tuned to that station. If he wishes to stay tuned, the user is to issue a stop_scan_command through the user key input device 16, and this info is thereafter transmitted, through the control signal 7 to the tuner 5, instructing the tuner to stay tuned to the station. If such a stop_scan_command is not issued during the predetermined scanning stop time, the scanning will continue as the predetermined scanning stop time expires.

According to this invention, the control unit 2 also comprises a memory 14, in which identification information of a latest stop frequency for the scanning is stored. The stop frequency is stored in the memory 14 each time the signal strength signal 8 is above the predetermined search_stop_level, and hence the scanning halts for a predetermined scanning stop time Ts. The frequency identification information of the stop frequency may for instance be supplied through the RDS data signal 9.

However, as described above, the RDS data signal 9 which is transmitted to the control unit 2 also comprises information regarding an alternative frequency pick list for the received signal 4, which is stored in an alternative frequency pick list memory (not shown) within the tuner 5. Hence, during the predetermined scanning stop time, the tuner may jump to another frequency within the alternative frequency pick list, for instance having a higher signal-to-noise ratio than the original stop frequency, although transmitting the same content. As will be described below, if the signal quality for the presently tuned frequency is not sufficient, the radio receiver unit will search for another frequency, transmitting the same content (i.e. being from the same station), within the alternative frequency picklist, having a better reception. A switch to another frequency within the alternative frequency picklist may be triggered by a reduced signal strength, an increased noise-level, an increase of disturbance from adjacent channels, or by a combination of the above parameters.

However, the frequency identification information stored in the memory 14 remains the same during the entire predetermined scanning stop time, i.e. identifying the original stop frequency. Hence, regardless of whether the tuner remains tuned to this original stop frequency for the entire predetermined scanning stop time, or if the tuned frequency changes one or more times to alternative frequencies within the alternative frequency pick list, the scanning will continue from the original stop frequency stored in the memory 14 after said scanning stop time, given that a stop_scan_command has not been issued. Preferably, the stop frequency is stored in the memory until a new stop frequency has been found in a subsequent scanning. In that case, if a stop_scan_command is issued before a new stop frequency has been found, the receiver unit jumps back to the first stop frequency, stored in the memory.

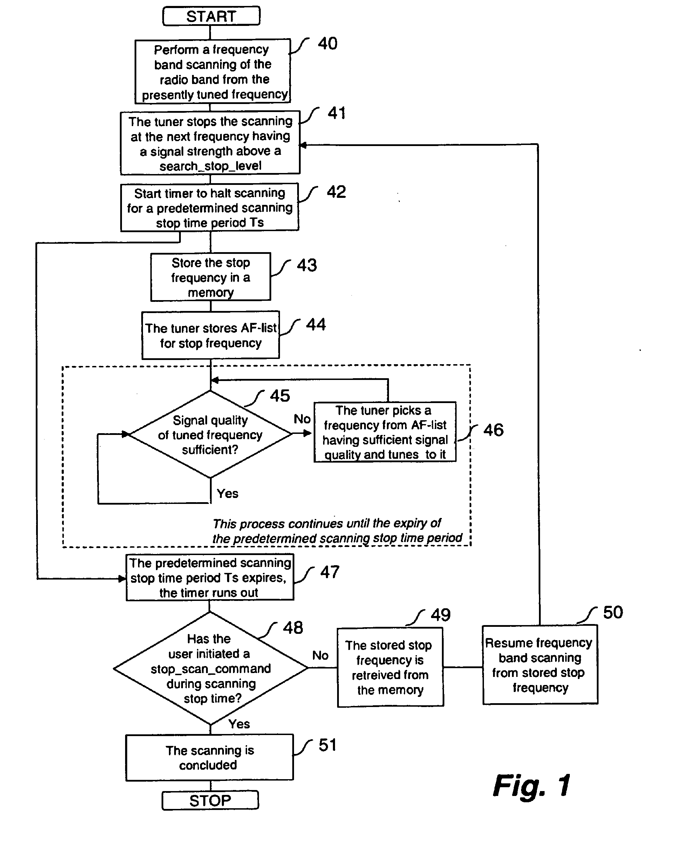

Referring to fig 1 and fig 2, control of the scanning in a radio receiver unit as disclosed in fig 1, is explained by means of flow charts.

At step 40 (at a time t1), a scanning of a frequency band is started from a presently tuned frequency f1. This is done by the user issuing a start_scan_command by maneuvering the user key input device 16.

At step 41, the tuner stops the scanning at a next frequency (f2) in the frequency band, having a signal strength above a predetermined search_stop_level. Thereby, the next frequency transmitted by a radio station on the frequency band is located. The predetermined search_stop_level is set so that it is likely that the frequency found actually is a frequency transmitting a radio content with a satisfactory signal quality to ensure a pleasant listening experience.

A step 42 (at a time t2), the scanning is halted for a predetermined scanning stop time Tₛ, for instance 10 seconds, and a timer is started for keeping track of this time. The predetermined scanning stop time allows the user to listen to the content transmitted by the station, and to determined whether he wishes to stay tuned to this station.

At step 43, the frequency (f2) revealed at step 41 is stored as a stop frequency in the memory 14. Information identifying the frequency is for instance submitted to the control unit 2 and the memory 14 through the RDS data signal 9.

At step 44, an alternative frequency pick list is identified for the stop frequency f2,the list for instance containing the two frequencies f5 and f6. Typically, this list contains more than two frequencies transmitting the same content. The alternative frequency pick list is usually contained in the RDS data signal. However, it shall be noted that an alternative frequency picklist may not be available for all stop frequencies. In that case, this step returns a "no_picklist available" signal or amn empty list, and the method continues to the next step

Thereafter, the method enters a loop, containing the steps 45 and 46, which is continued until the expiry of the predetermined scanning stop time Ts as set by the timer in step 42.

At step 45 , it is continuously monitored whether the tuned radio station (initially the radio station transmitting on the stop frequency f2) has a sufficiently high signal quality. This step may include monitoring of one or more of the following parameters: signal strength, signal-to-noise ratio, multipath noise, disturbances from adjacent stations, and frequency noise. As long as the signal quality is sufficient, as defined by a predetermined signal quality measure, this monitoring continues, but as soon as the signal quality is deemed to be not sufficient, i.e. not in line with the predetermined signal quality measure, the radio receiver unit initiate a search in the AF list for a frequency having a higher signal quality than the one presently tuned.

At step 46, if there is a frequency in the AF list, presently having a higher (and sufficient as described above) signal quality, the tuner picks this frequency (f5), and tunes to this frequency (at a time t3). Thereafter, the above monitoring continues with the presently tuned frequency, and this loop may be performed several times during the predetermined scanning stop time.

At step 47 the predetermined scanning stop time Ts expires, i.e. the timer runs out, which ends the loop described above with reference to step 45 and 46, and at this moment, the tuner is tuned to the frequency which was the last one tuned within the loop.

At step 48 it is checked if the user has initiated a stop_search_command during the predetermined scanning stop time. Such a command may be issued by the user, using the user key input device 16. If such a command has been issued, at step 51, the scanning is concluded, and hence the tuner stays tuned to the presently tuned station at the currently tuned frequency, until the AF functionality triggers a frequency switch within the AF list as indicated above, or until the user initiate a new scan, or some other function, or turns off the radio receiver off.

If a stop_scan_command has not been issued during the predetermined scanning stop time Tₛ (in this case t4-t2), in step 49 (at a time t4), the stored stop frequency f2 is retrieved from the memory 14, and thereafter, at step 50, the frequency band scanning is resumed from the stored stop frequency f2, and the scanning is continued (back to step 41), without any undesired frequency jumps.

A schematic illustration is disclosed in fig 2. In this example, the scanning starts at a time t1 at a start frequency f1, and at this point the user issues a start_scan_command. The scanning of the frequency band continues until the time t2, when a stop frequency f2, having a signal strength above a predetermined search_stop_level, is detected. The tuner then makes a halt in the scanning for a predetermined scanning stop time, during which (at a time t3) the tuner frequency is changed to the frequency f5, being a frequency from the alternative frequency pick list for f2, for the moment having a higher signal quality that the presently tuned frequency f2. After the predetermined scanning stop time Ts (at t4, i.e. the predetermined scanning stop time Tₛ=t4-t2), the user has still not issued a stop_scan_command, whereby the scanning of the frequency band is continued from the stop frequency f2, until a next stop frequency f3, having a signal strength above a predetermined search_stop_level, is detected at a time t5. The tuner then makes a halt in the scanning for a predetermined scanning stop time. The frequency f3 is not an RDS station and therefore it does not have an alternative frequency pick list. Hence, the receiver unit stays tuned to the frequency f3 during the entire predetermined scanning stop time. At a time t6, at the expiry of the predetermined scanning stop time, the receiver unit checks that no stop_scan_command has been issued during the predetermined scanning stop time, and thereafter the scanning of the frequency band continues. The scanning of the frequency band is continued from the stop frequency f3, until a next stop frequency f4, having a signal strength above a predetermined search_stop_level, is detected at a time t7. The user wishes to stay tuned to this frequency f4, and therefore issues a stop_scan_command during the predetermined scanning stop time, which concludes the scanning.

It shall be noted that the invention is not to be limited to the particular embodiments described above with reference to the accompanying drawings, but that various changes or modifications are possible for a man skilled in the art, without departing from the scope of the invention as defined by the appended claims.

In particular it shall be noted that several different measures for the signal strength, apart from the signal-to-noise ratio described above, may be applied.

It shall also be noted that the antenna described above may be replaced by a system comprising two or more separate antennas, and that the term antenna as used above is intended to include all such systems.

Further, at least the above described tuner, decoder, processor and memory may be incorporated in a single unit.

It shall also be noted that, although it is enough to store the stop frequency in the memory at least until the expiry of said predetermined scanning stop time period, the more preferred solution is that the stop frequency is stored in the memory at least until a next successful scanning locating a next stop frequency has been conducted.

### List of nomenclature

- 1.: Radio receiver unit
- 2.: Control unit
- 3.: Antenna
- 4.: Received signal
- 5.: Tuner
- 6.: Audio signal
- 7.: Control signal
- 8.: Signal strength signal
- 9.: RDS data signal
- 10.: Audio processor
- 11.: Amplifier
- 12.: Output signal
- 13.: Processor
- 14.: Memory
- 15.: Key processor
- 16.: User key input device
- 17.: Display
- 18.: Decoder

- Tₛ: Predetermined scanning stop time period
- f: frequency
- f₁: start frequency
- f₂: stop frequency
- f₃-f₆: example frequencies

## Claims

1. A radio receiver unit (1) for use in a radio network environment, the receiver unit (1) comprising means for enabling a scanning through a radio frequency band in search of a radio station transmitting a desired radio content,
wherein the receiver unit (1) is arranged to halt a scanning through the radio frequency band at a stop frequency (f₂) transmitted by a first radio station and having a signal quality above a predetermined search_stop_level, whereafter the radio receiver unit (1) is arranged to reproduce said first radio station for a predetermined scanning stop time period (Tₛ), wherein the receiver unit further comprises a memory (14), in which the stop frequency (f₂) is stored, at least until the expiry of said predetermined scanning stop time period (Tₛ)
wherein
said receiver unit (1) is arranged to resume the scanning through the radio frequency band from the stored stop frequency (f₂), at the expiry of said predetermined scanning stop time (Tₛ), unless a stop_scan_command has been issued during said predetermined scanning stop time (Tₛ)
**characterised in that**
said receiver unit (1) is arranged to, during said predetermined scanning stop time (Tₛ), reproduce said first radio station on any frequency, selected from an alternative frequency pick list containing said stop frequency (f₂), having signal quality above a predetermined search_stop_level.

2. A receiver unit as in claim 1, wherein the radio receiver unit is arranged to reproduce the first radio station on said stop frequency (f₂), for the predetermined scanning stop time (Tₛ), unless the signal quality for said stop frequency (f₂) falls below a predetermined threshold.

3. A receiver unit as in any one of the preceding claims, wherein said signal quality is a measure of at least one of signal strength, signal-to-noise ratio, multipath noise, disturbances from adjacent stations, and frequency noise, or a combination thereof.

4. A method of performing a frequency band scan to tune a radio receiver unit in a vehicle, comprising the steps of:
- scanning through the frequency band, from a start frequency through a subsequent band of frequencies,
- stopping the scan at a stop frequency (f₂) transmitted by a first radio station and having a signal level above a pre-determined search_stop_level,
- storing said stop frequency (f₂) in a memory,
- reproducing said first radio station , for a predetermined scanning stop time (Tₛ),
- continuing said scanning through the frequency band, starting the scanning at said stop frequency (f₂), stored in said memory,
wherein the step of continuing said scanning through the frequency band, further comprises the steps of
cheking whether a stop-scan-command has been issued during said predetermined scanning stop time (Tₛ), and,
- if such a stop-scan-command has not been issued, continuing said scanning through the frequency band, starting at said stop frequency (f₂), stored in said memory,
**characterised in that** said receiver unit (1) during said predetermined scanning stop time (Tₛ), reproduces said first radio station on any frequency, selected from an alternative frequency pick list containing said stop frequency (f₂), having signal quality above a predetermined search-stop level.

5. A method accroding to claim 4, **characterised in that** the step of reproducing said first radio station, for a predetermined scanning stop time (Tₛ),
further comprises the steps of:
- determining an alternative frequency pick list for said stop frequency (f₂),
- monitoring the signal quality of the presently tuned frequency,
- and, if the signal quality of the presently tuned frequency falls under a predetermined threshold, selecting an alternative frequency within said alternative frequency picklist, having a signal quality over a predetermined threshold and tuning said radio receiver (1) to this frequency.

6. A method accroding to claim 4, **characterised in that** the step of reproducing the first radio station, for a predetermined scanning stop time (Tₛ),
further comprises the steps of:
- determining an alternative frequency pick list for said stop frequency (f₂),
- monitoring the signal quality of a presently tuned frequency and the alternative frequencies of said alternative frequency pick list,
- and, if an alternative frequency in said alternative frequency pick list has a higher signal quality than the presently tuned frequency, tuning said radio receiver into said alternative frequency.

7. Method according to claim 5 or 6, wherein the step of monitoring the signal quality of a presently tuned frequency further comprises the step of:
monitoring at least one of the signal strength, signal-to-noise ratio, multipath noise, disturbances from adjacent stations, and frequency noise.

## Patentansprüche

1. Rundfunkempfängereinheit (1) zur Verwendung in einer Rundfunknetzumgebung, wobei die Empfängereinheit (1) Mittel zum Ermöglichen eines Suchlaufs durch ein Hochfrequenzband auf der Suche nach einer Rundfunkstation, die gewünschten Rundfunkinhalt sendet, umfaßt,
wobei die Empfängereinheit (1) dafür ausgelegt ist, einen Suchlauf durch das Hochfrequenzband bei einer Stoppfrequenz (f₂), die von einer ersten Rundfunkstation gesendet wird und eine Signalqualität über einem vorbestimmten such_stopp_pegel aufweist, anzuhalten, wobei die Rundfunkempfängereinheit (1) daraufhin dafür ausgelegt ist, die erste Rundfunkstation für einen vorbestimmten Suchlaufstoppzeitraum (Tₛ) wiederzugeben, wobei die Empfängereinheit ferner einen Speicher (14) umfaßt, in dem die Stoppfrequenz (f₂) zumindest bis zum Ablaufen des vorbestimmten Suchlaufstoppzeitraums (Tₛ) gespeichert wird, wobei
die Empfängereinheit (1) dafür ausgelegt ist, beim Ablauf des vorbestimmten Suchlaufstoppzeitraums (Tₛ) den Suchlauf durch das Hochfrequenzband von der gespeicherten Stoppfrequenz (f₂) an wiederaufzunehmen, wenn nicht während der vorbestimmten Suchlaufstoppzeit (Tₛ) ein suchlauf_stopp_befehl ausgegeben wurde, und **dadurch gekennzeichnet, daß**
die Empfängereinheit (1) dafür ausgelegt ist, während der vorbestimmten Suchlaufstoppzeit (Tₛ) die erste Rundfunkstation auf irgendeiner aus einer alternativen Frequenzauswahlliste, die Stoppfrequenz (f₂) enthält, ausgewählten Frequenz wiederzugeben, die eine Signalqualität über einem vorbestimmten such_stopp_pegel aufweist.

2. Empfängereinheit nach Anspruch 1, wobei die Rundfunkempfängereinheit dafür ausgelegt ist, die erste Rundfunkstation für die vorbestimmte Suchlaufstoppzeit (Tₛ) auf der Stoppfrequenz (f₂) wiederzugeben, wenn nicht die Signalqualität für die Stoppfrequenz (f₂) unter eine vorbestimmte Schwelle abfällt.

3. Empfängereinheit nach einem der vorhergehenden Ansprüche, wobei die Signalqualität ein Maß der Signalstärke, des Rauschabstands, des Mehrwegerauschens, von Störungen von benachbarten Stationen und/oder von Frequenzrauschen oder einer Kombination davon ist.

4. Verfahren zum Durchführen eines Frequenzbandsuchlaufs zum Abstimmen einer Rundfunkempfängereinheit in einem Fahrzeug, mit den folgenden Schritten:
Suchlauf durch das Frequenzband von einer Startfrequenz durch ein nachfolgendes Band von Frequenzen,
Stoppen des Suchlaufs bei einer Stoppfrequenz (f₂), die von einer ersten Rundfunkstation gesendet wird und eine Signalqualität über einem vorbestimmten such_stopp_pegel aufweist,
Speichern der Stoppfrequenz (f₂) in einem Speicher,
Wiedergeben der ersten Rundfunkstation für eine vorbestimmte Suchlaufstoppzeit (Tₛ),
Fortsetzen des Suchlaufs durch das Frequenzband, wobei der Suchlauf bei der im Speicher gespeicherten Stoppfrequenz (f₂) startet,
wobei der Schritt des Fortsetzens des Suchlaufs durch das Frequenzband ferner die folgenden Schritte umfaßt:
Prüfen, ob ein Suchlauf-Stopp-Befehl während der vorbestimmten Suchlaufstoppzeit (Tₛ) ausgegeben wurde, und
wenn kein solcher Suchlauf-Stopp-Befehl ausgegeben wurde, Fortsetzen des Suchlaufs durch das Frequenzband beginnend bei der im Speicher gespeicherten Stoppfrequenz (f₂),
**dadurch gekennzeichnet, daß** die Empfängereinheit (1) während der vorbestimmten Suchlaufstoppzeit (Tₛ) die erste Rundfunkstation auf irgendeiner aus einer alternativen Frequenzauswahlliste, die Stoppfrequenz (f₂) enthält, ausgewählten Frequenz wiedergibt, die eine Signalqualität über einem vorbestimmten such_stopp_pegel aufweist.

5. Verfahren nach Anspruch 4, **dadurch gekennzeichnet, daß** der Schritt des Wiedergebens der ersten Rundfunkstation für eine vorbestimmte Suchlaufstoppzeit (Tₛ) ferner die folgenden Schritte umfaßt:
Bestimmen einer alternativen Frequenzauswahlliste für die Stoppfrequenz (f₂),
Überwachen der Signalqualität der gerade eingestellten Frequenz,
und wenn die Signalqualität der gerade eingestellten Frequenz unter eine vorbestimmte Schwelle abfällt, Auswählen einer alternativen Frequenz in der alternativen Frequenzauswahlliste, die eine Signalqualität über einer vorbestimmten Schwelle aufweist, und Abstimmen des Rundfunkempfängers (1) auf diese Frequenz.

6. Verfahren nach Anspruch 4, **dadurch gekennzeichnet, daß** der Schritt des Wiedergebens der ersten Rundfunkstation für eine vorbestimmte Suchlaufstoppzeit (Tₛ) ferner die folgenden Schritte umfaßt:
Bestimmen einer alternativen Frequenzauswahlliste für die Stoppfrequenz (f₂),
Überwachen der Signalqualität der gerade eingestellten Frequenz und der alternativen Frequenzen der alternativen Frequenzauswahlliste,
und wenn eine alternative Frequenz in der alternativen Frequenzauswahlliste eine höhere Signalqualität als die gerade eingestellte Frequenz aufweist, Abstimmen des Rundfunkempfängers auf diese alternative Frequenz.

7. Verfahren nach Anspruch 5 oder 6, wobei der Schritt des Überwachens der Signalqualität einer gerade eingestellten Frequenz ferner den folgenden Schritt umfaßt:
Überwachen der Signalstärke, des Rauschabstands, des Mehrwegerauschens, von Störungen von benachbarten Stationen und/oder von Frequenzrauschen.

## Revendications

1. Unité de récepteur radio (1) pour une utilisation dans un environnement de réseau radio, l'unité de récepteur (1) comprenant des moyens pour activer un balayage sur une bande de fréquences radio à la recherche d'une station radio transmettant un contenu radio souhaité,
dans laquelle l'unité de récepteur (1) est agencée pour interrompre un balayage sur la bande de fréquences radio à une fréquence d'arrêt (f₂) transmise par une première station radio et ayant une qualité de signal au-dessus d'un niveau_d'arrêt_de_recherche prédéterminé, après quoi l'unité de récepteur radio (1) est agencée pour reproduire ladite première station radio pendant un intervalle de temps d'arrêt de balayage prédéterminé (Tₛ), dans laquelle l'unité de récepteur comprend en outre une mémoire (14), dans laquelle la fréquence d'arrêt (f₂) est stockée, au moins jusqu'à l'expiration dudit intervalle de temps d'arrêt de balayage prédéterminé (Tₛ)
dans laquelle
ladite unité de récepteur (1) est agencée pour reprendre le balayage sur la bande de fréquences radio depuis la fréquence d'arrêt (f₂) stockée, à l'expiration dudit temps d'arrêt de balayage prédéterminé (Tₛ), à moins qu'une commande_d'arrêt_de_balayage n'ait été émise pendant ledit temps d'arrêt de balayage prédéterminé (Tₛ)
**caractérisée en ce que**
ladite unité de récepteur (1) est agencée, pendant ledit temps d'arrêt de balayage prédéterminé (Tₛ), pour reproduire ladite première station radio sur une fréquence quelconque, sélectionnée parmi une liste de choix de fréquences alternatives contenant ladite fréquence d'arrêt (f₂), ayant une qualité de signal au-dessus d'un niveau_d'arrêt_de_recherche.

2. Unité de récepteur selon la revendication 1, dans laquelle l'unité de récepteur radio est agencée pour reproduire la première station radio sur ladite fréquence d'arrêt (f₂), pendant le temps d'arrêt de balayage prédéterminé (Tₛ), à moins que la qualité de signal pour ladite fréquence d'arrêt (f₂) ne baisse au-dessous d'un seuil prédéterminé.

3. Unité de récepteur selon l'une quelconque des revendications précédentes, dans laquelle ladite qualité de signal est une mesure d'au moins un parmi l'intensité de signal, le rapport signal sur bruit, le bruit à trajets multiples, les perturbations provenant de stations adjacentes et le bruit de fréquence, ou une combinaison de ceux-ci.

4. Procédé de réalisation d'un balayage de bande de fréquences pour syntoniser une unité de récepteur radio dans un véhicule, comprenant les étapes de :
- balayage sur la bande de fréquences, depuis une fréquence de début sur une bande ultérieure de fréquences,
- arrêt du balayage à une fréquence d'arrêt (f₂) transmise par une première station radio et ayant un niveau de signal au-dessus d'un niveau_d'arrêt_de_recherche prédéterminé,
- stockage de ladite fréquence d'arrêt (f₂) dans une mémoire,
- reproduction de ladite première station radio, pendant un temps d'arrêt de balayage prédéterminé (Tₛ),
- poursuite dudit balayage sur la bande de fréquences, débutant le balayage à ladite fréquence d'arrêt (f₂), stockée dans ladite mémoire,
dans laquelle l'étape de poursuite dudit balayage sur la bande de fréquences, comprend en outre les étapes de
- vérification si une commande_d'arrêt_de_balayage a été émise pendant ledit temps d'arrêt de balayage prédéterminé (Tₛ), et,
- si une telle commande_d'arrêt_de_balayage n'a pas été émise, poursuite dudit balayage sur la bande de fréquences, débutant à ladite fréquence d'arrêt (f₂), stockée dans ladite mémoire,
**caractérisée en ce que** ladite unité de récepteur (1) pendant ledit temps d'arrêt de balayage prédéterminé (Tₛ), reproduit ladite première station radio sur une fréquence quelconque, sélectionnée parmi une liste de choix de fréquences alternatives contenant ladite fréquence d'arrêt (f₂), ayant une qualité de signal au-dessus d'un niveau_d'arrêt_de_recherche.

5. Procédé selon la revendication 4, **caractérisé en ce que** l'étape de reproduction de ladite première station radio, pendant un temps d'arrêt de balayage prédéterminé (Tₛ),
comprend en outre les étapes de :
- détermination d'une liste de choix de fréquences alternatives pour ladite fréquence d'arrêt (f₂),
- surveillance de la qualité de signal de la fréquence actuellement syntonisée,
- et, si la qualité de signal de la fréquence actuellement syntonisée baisse au-dessous d'un seuil prédéterminé, sélection d'une fréquence alternative dans ladite liste de choix de fréquences alternatives, ayant une qualité de signal au-dessus d'un seuil prédéterminé et syntonisant ledit récepteur radio (1) sur cette fréquence.

6. Procédé selon la revendication 4, **caractérisé en ce que** l'étape de reproduction de la première station radio, pendant un temps d'arrêt de balayage prédéterminé (Tₛ),
comprend en outre les étapes de:
- détermination d'une liste de choix de fréquences alternatives pour ladite fréquence d'arrêt (f₂),
- surveillance de la qualité de signal d'une fréquence actuellement syntonisée et des fréquences alternatives de ladite liste de choix de fréquences alternatives,
- et, si une fréquence alternative dans ladite liste de choix de fréquences alternatives a une qualité de signal supérieure à la fréquence actuellement syntonisée, syntonisation dudit récepteur radio dans ladite fréquence alternative.

7. Procédé selon la revendication 5 ou 6, dans lequel l'étape de surveillance de la qualité de signal d'une fréquence actuellement syntonisée comprend en outre l'étape de :
surveillance d'au moins un parmi l'intensité de signal, le rapport signal sur bruit, le bruit à trajets multiples, les perturbations provenant de stations adjacentes et le bruit de fréquence.
